# EUROPÄISCHE PATENTSCHRIFT

(11) **EP 3 533 121 B1**
(45) Veröffentlichungstag und Bekanntmachung des Hinweises auf die Patenterteilung: **24.02.2021**
(21) Anmeldenummer: 17811854.3
(22) Anmeldetag: 27.10.2017
(51) Int. Cl.: H01H 9/02, H01H 9/04, H01H 13/06, H02B 1/052, H05K 5/02, H02B 1/40

(54) **GEHÄUSE FÜR EIN ELEKTRISCHES GERÄT**
CASING FOR AN ELECTRICAL DEVICE
BOITIER POUR UN APPAREIL ÉLECTRIQUE

(30) Priorität: 31.10.2016 DE 102016120734
(43) Veröffentlichungstag der Anmeldung: 04.09.2019
(73) Patentinhaber: Pilz GmbH & Co. KG, 73760 Ostfildern (DE)
(72) Erfinder: SEID, Jörg, 73760 Ostfildern (DE); HAMPE, Tobias, 73760 Ostfildern (DE)
(74) Vertreter: Schäperklaus, Jochen
(86) Internationale Anmeldenummer: PCT/EP2017/077650
(87) Internationale Veröffentlichungsnummer: WO 2018/078120

(56) Entgegenhaltungen:
- DE-T2- 69 300 295
- US-A- 6 059 129
- US-A1- 2015 115 044

## Beschreibung

Die vorliegende Erfindung betrifft ein Gehäuse für ein elektrisches Gerät, umfassend einen Gehäuseboden, der einen Anschlussabschnitt zum Anschluss des Gehäuses an eine Maschine, eine technische Anlage oder eine Gebäudewand aufweist, und zumindest ein Befestigungselement, das an einer Außenseite des Anschlussabschnitts vorgesehen ist, wobei das Befestigungselement so ausgebildet ist, dass es mit einem damit korrespondierenden Halteelement der Maschine, der technischen Anlage oder der Gebäudewand formschlüssig verbindbar ist, und wobei das Gehäuse mittels eines Gehäusedeckels verschließbar ist.

Gehäuse für ein elektrisches Gerät, das zum Beispiel ein Not-Halt-Gerät einer gefahrbringenden Maschine oder einer technischen Anlage sein kann, sind aus dem Stand der Technik in unterschiedlichen Ausführungsformen bekannt. Insbesondere bei Gehäusen für Not-Halt-Geräte ist es zum Beispiel bekannt, diese nach dem vorherigen Öffnen des Gehäuses mit ihrem Gehäuseboden fest mit einer Unterlage oder einer Halterung zu verschrauben. Um die Montage besonders einfach zu gestalten, sind elektrische Geräte bekannt, die bereits herstellerseitig vollständig verdrahtet sein können und bei der Montage werkzeuglos an einer dafür vorbereiteten, an der Maschine beziehungsweise technischen Anlage vorgesehenen Halterung befestigt werden können, insbesondere auf ein Halteelement der Halterung aufgerastet werden können. Derartige Gehäuse haben den Nachteil, dass das Befestigungselement, mit dem das Gehäuse mit dem Halteelement verrastet wird, von außen zugänglich ist. Daher können diese elektrischen Geräte nach der Installation wieder problemlos und mit wenig Aufwand deinstalliert und anschließend gegebenenfalls neu installiert lassen, ohne dass dieses nachträglich erkennbar wäre. Ein unautorisiertes Deinstallieren sowie erneutes Installieren elektrischer Geräte kann insbesondere bei sicherheitskritischen Maschinen oder technischen Anlagen problematisch sein.

Aus der DE 195 04 762 C2 ist eine Vorrichtung bekannt, um ein Gehäuse eines elektrischen Geräts auf ein Tragschienenprofil aufzurasten. Der Entriegelungsmechanismus besteht aus einem Zugstab, der seitlich oder innerhalb des Gehäuses angebracht sein kann. Durch Ziehen an dem Zugstab wird an der Unterseite des Gehäuses ein Spreizbügel in seine Betriebsposition bewegt und das Gehäuse kann von der Tragschiene abgenommen werden.

Die DE 10 2015 201 916 A1 offenbart ein auf eine Hutschiene aufrastbares Gehäuse eines elektrischen Geräts. Die Verriegelung des Gehäuses an der Halterung erfolgt durch ein Exzenterelement an der Rückseite des Gehäuses. Dabei wird das Exzenterelement von der Vorderseite des Gehäuses mittels eines Drehstabes und eines Bedienelements drehbar betätigt. Das Gehäuse ist mitsamt der Verriegelungsvorrichtung demontierbar.

Bei diesen beiden vorstehend genannten Lösungen besteht keine Möglichkeit, eine unautorisierte Demontage des Gehäuses von der Halterung zu erfassen. Weiterhin weisen diese Gehäuse entsprechende Öffnungen auf, durch die der Zugstab beziehungsweise der Drehstab hindurchgeführt wird. Dadurch ist es nicht oder nur mit einem sehr hohen Aufwand möglich, ein Gehäuse mit einer erhöhten Schutzart, insbesondere mit der Schutzart IP65, zu schaffen.

Aus der DE 693 00 295 T2 ist ein gattungsgemäßes Gehäuse für ein elektrisches Gerät mit den Merkmalen des Oberbegriffs des Anspruchs 1 bekannt.

Ein weiteres Gehäuse für ein elektrisches Gerät ist aus der US 2015/115044 A1 bekannt.

Die vorliegende Erfindung macht es sich zur Aufgabe, ein Gehäuse der eingangs genannten Art zur Verfügung zu stellen, das auf einfache Weise an einem Halteelement einer Halterung befestigt werden kann und einen verbesserten Schutz vor einer unautorisierten Demontage bietet.

Die Lösung dieser Aufgabe liefert ein gattungsgemäßes Gehäuse mit den Merkmalen des kennzeichnenden Teils des Anspruchs 1. Die Unteransprüche betreffen vorteilhafte Weiterbildungen der Erfindung. Ein erfindungsgemäßes Gehäuse zeichnet sich dadurch aus, dass der Anschlussabschnitt eine konzentrische, sich um das Befestigungselement und/oder das Entriegelungselement herum erstreckende, elastisch verformbare Wellenstruktur aufweist. Dadurch kann die elastische Verformbarkeit des Anschlussabschnitts in einfacher Weise erreicht werden. Vorzugsweise kann die elastisch verformbare Wellenstruktur durch zumindest zwei ringförmige Erhöhungen und zumindest eine ringförmige Vertiefung zwischen den Erhöhungen gebildet sein. Diese Wellenstruktur reduziert die Steifigkeit des Anschlussabschnitts und ermöglicht so auf einfache Weise dessen elastische Verformung. Das Gehäuse kann nur nach dem Entfernen des Gehäusedeckels wieder von der Halterung gelöst werden, da nur dann das mit dem Befestigungselement in Wirkverbindung stehende Entriegelungselement für einen Benutzer erreichbar ist und betätigt werden kann. Der Anschlussabschnitt mit dem Befestigungselement ist so gestaltet, dass das Befestigungselement nach dem Anbringen des Gehäuses an dem Halteelement der maschinen- beziehungsweise anlagenseitigen oder auch gebäudeseitigen Halterung von dem Gehäuse verdeckt ist und somit von außen nicht zugänglich ist, so dass das Gehäuse nicht zerstörungsfrei demontiert werden kann. Vorzugsweise weist das Gehäuse zumindest ein Manipulationsschutzmittel auf, das so ausgebildet ist, dass es bei einem Öffnen des Gehäuses beschädigt wird. Das Manipulationsschutzmittel kann zum Beispiel ein Aufkleber sein, mittels dessen eine Trennfuge zwischen dem Gehäuse und dem Gehäusedeckel oder zumindest eines der Befestigungsmittel, mit Hilfe dessen der Gehäusedeckel an dem Gehäuse befestigt werden kann, überklebt ist. Ein Öffnen des Gehäuses führt zu einer Beschädigung des Aufklebers. Eine Manipulation an dem Gehäuse durch unautorisiertes Öffnen kann somit zuverlässig erkannt werden. Im Falle eines Defekts kann das Gehäuse in kurzer Zeit auch von fachfremden Personen ausgetauscht werden. Dazu muss lediglich der Gehäusedeckel abgenommen werden und das Entriegelungselement betätigt werden. Eine Demontage des Gehäuses, insbesondere zu Reparatur- oder Austauschzwecken, ist allerdings ganz bewusst nicht ohne das Verletzen des Manipulationsschutzmittels möglich. Die Montage des Gehäuses ist ebenfalls sehr einfach, da das Gehäuse zu Montagezwecken nicht geöffnet werden muss. Ein weiterer Vorteil des Gehäuses besteht darin, dass das Gehäuse keine Öffnungen aufweist, durch die ein Handhabungsmittel für das Entriegelungselement von außen hindurchgeführt werden muss. Dadurch ist es sehr einfach möglich, ein Gehäuse mit einer erhöhten Schutzart, insbesondere mit der Schutzart IP65, zu schaffen.

Um bei der Entriegelung des Gehäuses eine optimale Kraftübertragung von dem Entriegelungselement zum Befestigungselement zu erreichen, wird in einer bevorzugten Ausführungsform vorgeschlagen, dass das Befestigungselement und das Entriegelungselement einander gegenüberliegend an dem Anschlussabschnitt angeordnet sind.

Um die Herstellung des Gehäuses zu vereinfachen, kann in einer besonders vorteilhaften Ausführungsform vorgesehen sein, dass das Befestigungselement integral mit dem Anschlussabschnitt ausgebildet ist. Ebenso vorteilhaft ist es, dass das Entriegelungselement integral mit dem Anschlussabschnitt ausgebildet ist. Von besonderem Vorteil ist es, wenn sowohl das Befestigungselement als auch das Entriegelungselement integral mit dem Anschlussabschnitt ausgebildet sind, da in dieser Ausführungsform keine zusätzlichen Herstellungs- und Montageschritte erforderlich sind, um das Befestigungselement und das Entriegelungselement herzustellen und an dem Anschlussabschnitt zu befestigen. Es ist aber grundsätzlich auch möglich, das Befestigungselement und/oder das Entriegelungselement als separate Bauteile auszuführen und diese in geeigneter Weise an dem Anschlussabschnitt zu befestigen.

In einer bevorzugten Ausführungsform kann das Entriegelungselement so ausgebildet sein, dass es mittels eines Greifwerkzeugs - beispielsweise mittels einer Greifzange - greifbar ist. Diese Ausgestaltung des Entriegelungselements schafft eine einfache und für einen Benutzer intuitive Art der Entriegelung des Gehäuses von dem Halteelement.

Vorzugsweise kann das Befestigungselement so ausgebildet sein, dass es durch Ausüben einer Zugkraft von dem Halteelement der Maschine, der technischen Anlage oder der Gebäudewand lösbar ist.

Um die Herstellung des Gehäuses besonders einfach zu gestalten, wird in einer besonders vorteilhaften Ausführungsform vorgeschlagen, dass der Anschlussabschnitt integral mit dem Gehäuseboden ausgebildet ist. Das Gehäuse ist somit vorzugsweise ein einstückiges Bauteil, das zum Beispiel durch ein Kunststoff-Spritzgussverfahren hergestellt werden kann. Da der Anschlussabschnitt integral mit dem Gehäuseboden ausgebildet ist und bereits bei der Herstellung des Gehäuses erzeugt wird, entfallen zusätzliche Montageschritte, um den Anschlussabschnitt an dem Gehäuseboden zu befestigen und in geeigneter Weise abzudichten, sofern es die zu erreichende Schutzart des Gehäuses erfordern sollte. In diesem Zusammenhang ist es besonders vorteilhaft, dass das Befestigungselement und das Entriegelungselement integral mit dem Anschlussabschnitt ausgebildet sind.

Grundsätzlich ist es aber auch denkbar, dass der Anschlussabschnitt als separates Bauteil ausgebildet ist, das in eine passend geformte, innerhalb des Gehäusebodens vorgesehene Aufnahmeöffnung eingesetzt wird und in dieser festgelegt wird. Diese Variante hat jedoch den Nachteil, dass die Verbindung des Anschlussabschnitts mit dem Gehäuse nur mit einem hohen Aufwand abgedichtet werden kann. Diese Ausführungsform eignet sich daher eher für Gehäuse mit einer niedrigen Schutzart.

Weitere Merkmale und Vorteile der vorliegenden Erfindung werden deutlich anhand der nachfolgenden Beschreibung eines bevorzugten Ausführungsbeispiels unter Bezugnahme auf die beiliegenden Abbildungen. Darin zeigen:
- Fig. 1: eine perspektivische Ansicht eines Gehäuses für ein elektrisches Gerät, das gemäß einem bevorzugten Ausführungsbeispiel der vorliegenden Erfindung ausgeführt ist,
- Fig. 2: eine Seitenansicht des Gehäuses,
- Fig. 3: einen Längsschnitt durch das Gehäuse,
- Fig. 4: eine Draufsicht auf das Gehäuse.

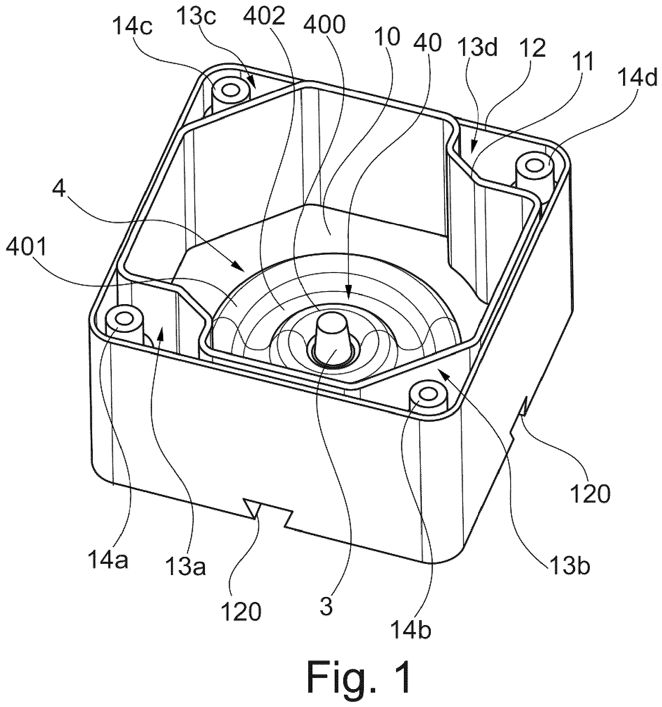

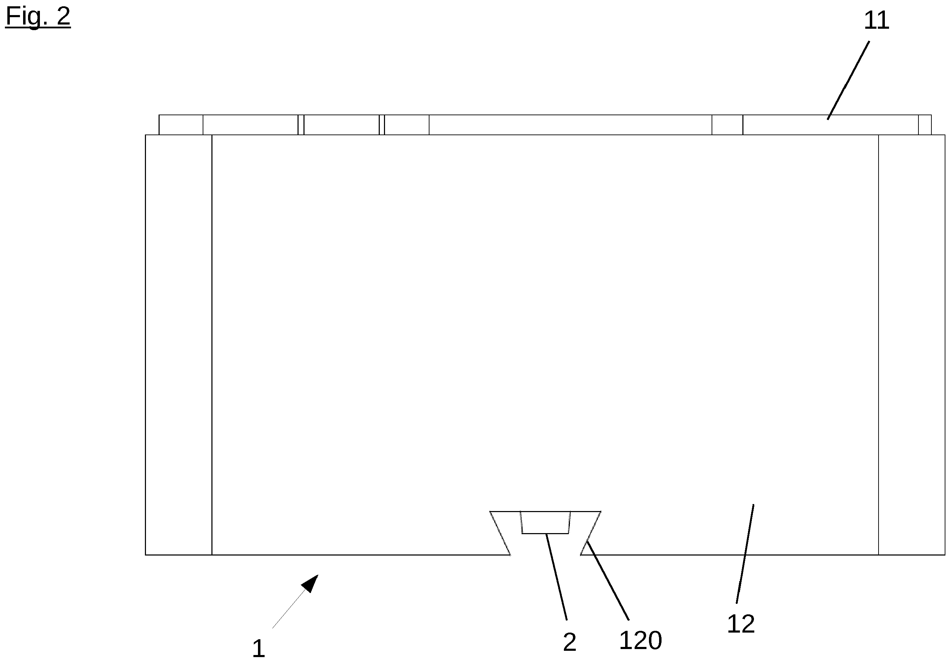

Unter Bezugnahme auf Fig. 1 bis 4 umfasst ein Gehäuse 1 für ein elektrisches Gerät, wie zum Beispiel ein Not-Halt-Gerät einer Maschine oder technischen Anlage, einen Gehäuseboden 10, eine umlaufende innere Gehäusewandung 11 sowie eine umlaufende äußere Gehäusewandung 12. Das Gehäuse 1, das aus Kunststoff hergestellt ist, weist einen im Wesentlichen rechteckigen, vorliegend im Wesentlichen quadratischen, Umriss auf. Die umlaufende - d.h. sich in Umfangsrichtung erstreckende - innere Wandung 11 begrenzt einen inneren Aufnahmeraum des Gehäuses 1, innerhalb dessen Bauteilkomponenten des elektrischen Geräts untergebracht werden können. Das Gehäuse 1 kann mittels eines Gehäusedeckels, der ebenfalls aus Kunststoff hergestellt ist, verschlossen und derart abgedichtet werden, dass es eine erhöhte Schutzart, insbesondere die Schutzart IP65, erreichen kann. Ein elektrischer Anschluss kann zum Beispiel durch Anstecken einer industrieüblichen, fünfpoligen M12-Steckverbindung realisiert werden.

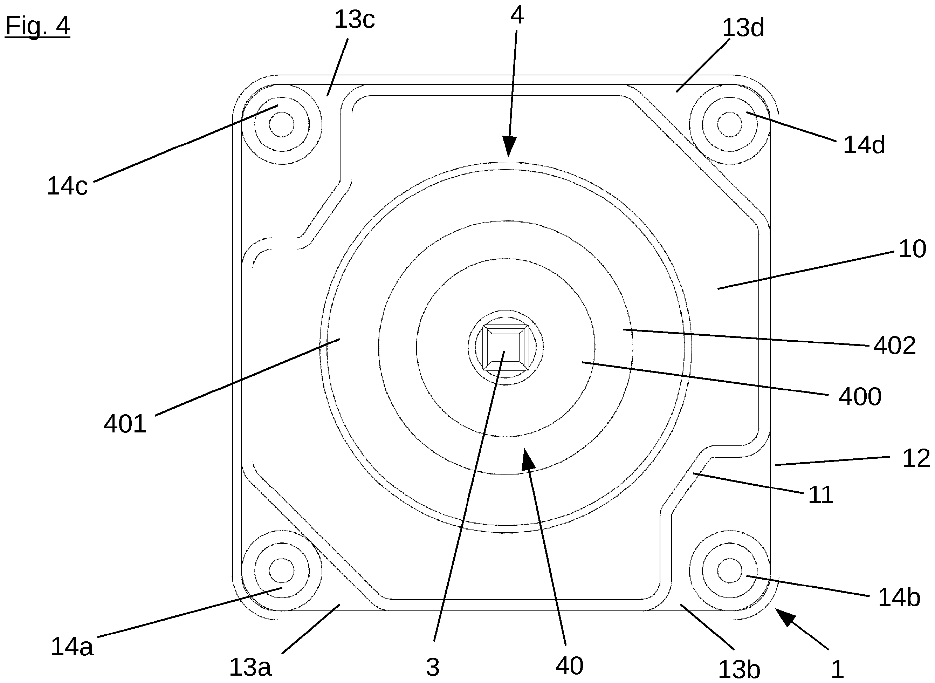

Wie in Fig. 1 und 4 zu erkennen, ist die innere Gehäusewandung 11 in allen vier Eckbereichen des Gehäuses 1 von der äußeren Gehäusewandung 12 beabstandet. Dadurch wird in jedem dieser vier Eckbereiche ein Zwischenraum 13a, 13b, 13c, 13d geschaffen, innerhalb dessen jeweils ein hohlzylindrischer Aufnahmeabschnitt 14a, 14b, 14c, 14d ausgebildet ist. Das Gehäuse 1 kann mittels des hier nicht dargestellten Gehäusedeckels verschlossen werden, der in seinen vier Eckbereichen jeweils eine Durchstecköffnung aufweist. Diese Durchstecköffnungen fluchten nach dem Aufsetzen des Gehäusedeckels auf das Gehäuse 1 jeweils mit einem der hohlzylindrischen Aufnahmeabschnitte 14a, 14b, 14c, 14d. Anschließend kann durch jede der Durchstecköffnungen jeweils eine Befestigungsschraube hindurchgeführt und mit dem mit der jeweiligen Durchstecköffnung fluchtenden Aufnahmeabschnitt 14a, 14b, 14c, 14d verschraubt werden. Vorzugsweise weist das Gehäuse 1 zumindest ein Manipulationsschutzmittel auf, das so ausgebildet ist, dass ein Öffnen des Gehäuses 1 durch Abnehmen des Gehäusedeckels zuverlässig erkannt werden kann. Das Manipulationsschutzmittel kann zum Beispiel ein Aufkleber sein, mittels dessen eine Trennfuge zwischen dem Gehäuse 1 und dem Gehäusedeckel oder zumindest eine der Befestigungsschrauben überklebt sein kann. Ein Öffnen des Gehäuses 1 führt zu einer irreversiblen Beschädigung des Aufklebers und kann somit zuverlässig erkannt werden.

Der Gehäuseboden 10 weist einen elastisch verformbaren Anschlussabschnitt 4 auf, der an einer Außenseite zumindest ein Befestigungselement 2 umfasst, welches so ausgebildet ist, dass es mit einem damit korrespondierenden Halteelement, das an einer Maschine oder einer technischen Anlage oder auch an einer Gebäudewand angeordnet ist, formschlüssig verbindbar ist. Das Befestigungselement 2 ist integral mit dem Anschlussabschnitt 4 ausgebildet. Das Halteelement, mit dem das Gehäuse 1 verbunden wird, kann zum Beispiel Teil einer Halteschiene, insbesondere einer Hutschiene, sein und vorzugsweise als Rastelement ausgebildet sein. Mit diesem Rastelement kann das Befestigungselement 2 bei der Montage - und zwar ohne dass das Gehäuse 1 vorher geöffnet werden muss - verrastet werden. Das Befestigungselement 2 ist in einem mittleren Bereich der Außenseite des Anschlussabschnitts 4 angeordnet und wird somit nach der Befestigung an dem Halteelement durch das Gehäuse 1 verdeckt. Dadurch ergibt sich der Vorteil, dass das Befestigungselement 2 von außen nicht zugänglich ist und das Gehäuse 1 nicht mehr ohne Weiteres zerstörungsfrei von dem Halteelement entfernt werden kann.

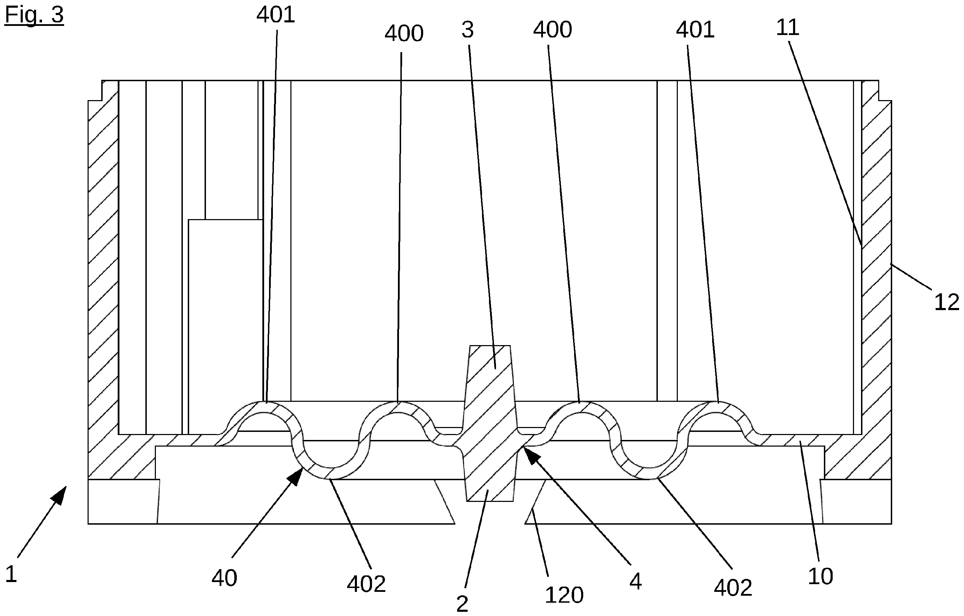

Um das Gehäuse 1 zum Beispiel im Falle eines Defekts auf einfache Weise von dem Halteelement lösen zu können, ist der Gehäuseboden 10 durch das Vorsehen des Anschlussabschnitts 4 zumindest in demjenigen Bereich, in dem an der Außenseite das Befestigungselement 2 ausgebildet ist, elastisch verformbar gestaltet. Der Anschlussabschnitt 4 weist zur Reduzierung der Steifigkeit und zur Bereitstellung der elastischen Verformbarkeit eine konzentrische, sich um das Befestigungselement 2 herum erstreckende Wellenstruktur 40 auf, die durch zwei ringförmige, in das Innere des Gehäuses 1 weisende Erhöhungen 400, 401 und eine ringförmige, nach außen weisende Vertiefung 402 zwischen den beiden Erhöhungen 400, 401 gebildet ist. Die konzentrische Wellenstruktur 40, die am besten in Fig. 3 zu erkennen ist, mit den beiden ringförmigen Erhöhungen 400, 401 und der dazwischen vorgesehenen Vertiefung 402 verleiht dem Anschlussabschnitt 4 die notwendige Elastizität, so dass er durch die Einwirkung einer Druck- oder Zugkraft elastisch verformt werden kann. Wie in Fig. 3 zu erkennen weist der Anschlussabschnitt 4 ein Entriegelungselement 3 auf, das dem Befestigungselement 2 gegenüberliegt und sich in das Innere des Gehäuses 1 erstreckt. Dieses Entriegelungselement 3, dessen Funktion weiter unten näher erläutert wird, ist ebenfalls integral mit dem Anschlussabschnitt 4 ausgebildet. Um die vorstehend erläuterte konzentrische Wellenstruktur 40 des Anschlussabschnitts 4 mit den Erhöhungen 400, 401 sowie der sich zwischen diesen erstreckenden Vertiefung 402 auch in der perspektivischen Darstellung gemäß Fig. 1 zu veranschaulichen, wurden dort ganz bewusst links und rechts von dem Entriegelungselement 3 zwei real nicht vorhandene und somit ausschließlich Visualisierungszwecken dienende "Wellenlinien" eingezeichnet.

Die äußere Gehäusewandung 12 weist in einem unteren Bereich jeder ihrer vier Seiten jeweils eine Ausnehmung 120 auf, die an die Kontur einer Halteschiene, an der das Gehäuse 1 befestigt werden soll, angepasst ist. Vorliegend sind die Ausnehmungen 120 so geformt, dass das Gehäuse 1 für eine Montage an einer schwalbenschwanzartig geformten Halteschiene geeignet ist. Die beiden Ausnehmungen 120 zweier einander gegenüberliegender Seiten der äußeren Gehäusewandung 12 sind so angeordnet, dass sie miteinander fluchten, so dass das Gehäuse 1 bei der Montage auf einfache Weise auf die Halteschiene aufgeschoben werden kann. Dadurch, dass an jeder Seite der äußeren Gehäusewandung 12 jeweils eine Ausnehmung vorgesehen ist, kann das Gehäuse 1 in zwei unterschiedlichen, um 90° zueinander gedrehten Ausrichtungen an der Halteschiene montiert werden. Bei dem Aufschieben auf die Halteschiene wird das Befestigungselement 2 durch den Kontakt mit der Halteschiene zunächst nach innen gedrückt, so dass sich die konzentrische Wellenstruktur 40 elastisch nach innen verformt. Wenn das Befestigungselement 2 bei der weiteren Verschiebebewegung auf der Halteschiene schließlich das Halteelement erreicht, greift das Befestigungselement 2 formschlüssig in das Halteelement ein und verrastet mit diesem. Die Wellenstruktur 40 entspannt sich und sichert so die formschlüssige Verbindung des Befestigungselements 2 mit dem Halteelement.

Das Gehäuse 1 ist während des Betriebs hermetisch dicht, da es mittels des Gehäusedeckels verschlossen ist. Um zum Beispiel im Falle eines Defektes des elektrischen Geräts das Gehäuse 1 von der Halterung lösen zu können, müssen in einem ersten Schritt die Befestigungsschrauben gelöst werden, so dass der Gehäusedeckel vom Gehäuse 1 entfernt werden kann. Dabei wird das Manipulationsschutzmittel des Gehäuses 1 beschädigt. Anschließend kann ein Benutzer das Entriegelungselement 3 mit einem Greifwerkzeug, insbesondere mit einer Greifzange, ergreifen und eine Zugkraft auf das Entriegelungselement 3 ausüben. Die konzentrische, sich um das Befestigungselement 2 und um das Entriegelungselement 3 herum erstreckende Wellenstruktur 40 wird durch die Einwirkung der Zugkraft nach innen gezogen und derart elastisch verformt, dass das Befestigungselement 2 mit dem Halteelement außer Eingriff gebracht wird und somit die formschlüssige Verbindung gelöst wird. Das Gehäuse 1 kann dann von einem Benutzer entlang der Halteschiene geschoben werden und schließlich von dieser entfernt werden.

Vorzugsweise ist das gesamte Gehäuse 1 einstückig ausgebildet. Das bedeutet, dass der Anschlussabschnitt 4, der mit dem Befestigungselement 2 und mit dem Entriegelungselement 3 den Verriegelungs- und Entriegelungsmechanismus für das Gehäuse 1 bereitstellt, integral mit dem Gehäuseboden 10 ausgebildet ist und somit kein separates und in einem zusätzlichen Montageschritt zu montierendes Bauteil ist.

Ein Vorteil des hier offenbarten Gehäuses 1 besteht darin, dass es - ohne dass es zuvor geöffnet werden müsste - auf einfache Weise werkzeuglos an einem Halteelement, insbesondere an einem Halteelement einer Halteschiene, befestigt werden kann. Der durch das Befestigungselement 2 und das Entriegelungselement 3 gebildete Verriegelungs- und Entrieglungsmechanismus ist mechanisch sehr robust ausgeführt und kommt ohne filigrane Bauteile aus, die leicht beschädigt werden könnten und somit das Gehäuse 1 unbrauchbar machen könnten. Ein unautorisiertes wie auch ein autorisiertes (insbesondere zu Reparaturzwecken erfolgendes) Öffnen des Gehäuses 1 ist durch die Beschädigung des Manipulationsschutzmittels nachträglich erkennbar. Dadurch eignet sich das Gehäuse 1 auch für elektrische Geräte, die in sicherheitskritischen Maschinen oder technischen Anlagen zum Einsatz kommen. Ein weiterer Vorteil des Gehäuses 1 besteht darin, dass es problemlos wiederverwendet werden kann. Das Gehäuse 1 kann zum Beispiel nach einer Reparatur wieder mit einem Manipulationsschutzmittel versehen und dadurch versiegelt werden und steht anschließend zur erneuten Installation bereit.

Das Gehäuse 1 mit dem integral mit diesem ausgebildeten Anschlussabschnitt 4 kann sehr einfach in einem Kunststoff-Spritzgussverfahren hergestellt werden. Das Gehäuse 1 ist werkzeugfallend. Das bedeutet, dass nach Abschluss des Spritzgussvorgangs keine zusätzlichen Montageschritte erforderlich sind, um das Gehäuse 1 fertigzustellen. Die Herstellung des Gehäuses 1 mitsamt des Verriegelungs- und Entriegelungsmechanismus ist mittels eines einfachen Auf-Zu-Werkzeugs möglich.

Grundsätzlich ist es auch denkbar, dass der Anschlussabschnitt 4 als separates Bauteil ausgebildet ist, das in eine passend geformte, innerhalb des Gehäusebodens 10 vorgesehene Aufnahmeöffnung eingesetzt wird und in dieser festgelegt wird. Diese Variante hat jedoch den Nachteil, dass die Verbindung des Anschlussabschnitts 4 mit dem Gehäuse 1 nur sehr schwierig abgedichtet werden kann. Diese Ausführungsform eignet sich daher eher für Gehäuse 1 mit einer niedrigen Schutzart.

Prinzipiell ist es auch möglich, das Befestigungselement 2 und/oder das Entriegelungselement 3 nicht integral mit dem Anschlussabschnitt 4 auszubilden. Diese Variante hat allerdings den Nachteil, dass zusätzliche Schritte notwendig sind, um das Befestigungselement 2 und/oder das Entriegelungselement 3 herzustellen und an dem Anschlussabschnitt 4 zu befestigen. Die integrale Ausbildung des Befestigungselements 2 und/oder des Entriegelungselements 3 mit dem Anschlussabschnitt 4 ist somit erheblich vorteilhafter.

## Patentansprüche

1. Gehäuse (1) für ein elektrisches Gerät, umfassend
- einen Gehäuseboden (10), der einen Anschlussabschnitt (4) zum Anschluss des Gehäuses (1) an eine Maschine, eine technische Anlage oder eine Gebäudewand aufweist, und
- zumindest ein Befestigungselement (2), das an einer Außenseite des Anschlussabschnitts (4) vorgesehen ist, wobei das Befestigungselement (2) so ausgebildet ist, dass es mit einem damit korrespondierenden Halteelement der Maschine, der technischen Anlage oder der Gebäudewand formschlüssig verbindbar ist, und wobei das Gehäuse (1) mittels eines Gehäusedeckels verschließbar ist, wobei der Anschlussabschnitt (4) elastisch verformbar ausgebildet ist und an einer Innenseite ein von einem Benutzer betätigbares Entriegelungselement (3) aufweist, das mit dem Befestigungselement (2) in Wirkverbindung steht und so ausgebildet ist, dass es nur bei geöffnetem Gehäuse (1) von innen betätigbar ist, um die formschlüssige Verbindung des Befestigungselements (2) mit dem Halteelement der Maschine, der technischen Anlage oder der Gebäudewand zu lösen, **dadurch gekennzeichnet, dass** der Anschlussabschnitt (4) eine konzentrische, sich um das Befestigungselement (2) und/oder das Entriegelungselement (3) herum erstreckende, elastisch verformbare Wellenstruktur (40) aufweist.

2. Gehäuse (1) nach Anspruch 1, **dadurch gekennzeichnet, dass** das Befestigungselement (2) und das Entriegelungselement (3) einander gegenüberliegend an dem Anschlussabschnitt (4) angeordnet sind.

3. Gehäuse (1) nach einem der Ansprüche 1 oder 2, **dadurch gekennzeichnet, dass** das Befestigungselement (2) integral mit dem Anschlussabschnitt (4) ausgebildet ist.

4. Gehäuse (1) nach einem der Ansprüche 1 bis 3, **dadurch gekennzeichnet, dass** das Entriegelungselement (3) integral mit dem Anschlussabschnitt (4) ausgebildet ist.

5. Gehäuse (1) nach einem der Ansprüche 1 bis 4, **dadurch gekennzeichnet, dass** das Entriegelungselement (3) so ausgebildet ist, dass es mittels eines Greifwerkzeugs greifbar ist.

6. Gehäuse (1) nach einem der Ansprüche 1 bis 5, **dadurch gekennzeichnet, dass** das Befestigungselement (2) so ausgebildet ist, dass es durch Ausüben einer Zugkraft von dem Halteelement der Maschine, der technischen Anlage oder der Gebäudewand lösbar ist.

7. Gehäuse (1) nach einem der Ansprüche 1 bis 6, **dadurch gekennzeichnet, dass** die elastisch verformbare Wellenstruktur (40) durch zumindest zwei ringförmige Erhöhungen (400, 401) und zumindest eine ringförmige Vertiefung (402) zwischen den Erhöhungen (400, 401) gebildet ist.

8. Gehäuse (1) nach einem der Ansprüche 1 bis 7, **dadurch gekennzeichnet, dass** der Anschlussabschnitt (4) integral mit dem Gehäuseboden (10) ausgebildet ist.

## Claims

1. Housing (1) for an electrical device, comprising:
- a housing bottom (10) which has a connecting section (4) to connect the housing (1) to a machine, a technical system, or a building wall, and
- at least one fastening element (2) provided on an outer face of the connecting section (4), wherein the fastening element (2) is designed such that it is connectable in a form-fitting manner to a corresponding retaining element of the machine, the technical system, or the building wall, and wherein the housing (1) is closeable by means of a housing cover, wherein the connecting section (4) is elastically deformable and has, on an inner face, an unlocking element (3) being actuatable by a user, which is operatively connected to the fastening element (2) and which is designed to be only actuatable from the inside when the housing (1) is open in order to release the form-fitting connection of the fastening element (2) to the retaining element of the machine, the technical system, or the building wall, **characterised in that** the connecting section (4) has a concentric, elastically deformable undulating structure (40) extending around the fastening element (2) and/or the unlocking element (3).

2. Housing (1) according to claim 1, **characterised in that** the fastening element (2) and the unlocking element (3) are arranged opposite one another on the connecting section (4).

3. Housing (1) according to any of claims 1 or 2, **characterised in that** the fastening element (2) is integrally formed with the connecting section (4).

4. Housing (1) according to any of claims 1 to 3, **characterised in that** the unlocking element (3) is integrally formed with the connecting section (4).

5. Housing (1) according to any of claims 1 to 4, **characterised in that** the unlocking element (3) is designed to be grippable by a gripping tool.

6. Housing (1) according to any of claims 1 to 5, **characterised in that** the fastening element (2) is designed to be releasable from the retaining element of the machine, the technical system, or the building wall in response to exertion of a tensile force.

7. Housing (1) according to any of claims 1 to 6, **characterised in that** the elastically deformable undulating structure (40) is formed by at least two ring-shaped ridges (400, 401) and at least one ring-shaped indentation (402) between the ridges (400, 401).

8. Housing (1) according to any of claims 1 to 7, **characterised in that** the connecting section (4) is integrally formed with the housing bottom (10).

## Revendications

1. Boîtier (1) pour un appareil électrique, comprenant
- un fond de boîtier (10) qui présente une section de raccordement (4) pour raccorder le boîtier (1) à une machine, une installation technique ou un mur de bâtiment, et
- au moins un élément de fixation (2) qui est prévu sur un côté extérieur de la section de raccordement (4), dans lequel l'élément de fixation (2) est réalisé de sorte qu'il peut être relié par complémentarité de formes à un élément de retenue correspondant de la machine, de l'installation technique ou du mur de bâtiment, et dans lequel le boîtier (1) peut être fermé au moyen d'un couvercle de boîtier, dans lequel la section de raccordement (4) est réalisée de manière élastiquement déformable et présente sur un côté intérieur un élément de dégagement (3) pouvant être actionné par un utilisateur, lequel se trouve en liaison fonctionnelle avec l'élément de fixation (2) et est réalisé de sorte qu'il ne peut être actionné de l'intérieur que lorsque le boîtier (1) est ouvert, pour libérer la liaison par complémentarité de formes de l'élément de fixation (2) avec l'élément de retenue de la machine, de l'installation technique ou du mur de bâtiment, **caractérisé en ce que** la section de raccordement (4) présente une structure ondulée concentrique élastiquement déformable (40) s'étendant autour de l'élément de fixation (2) et/ou de l'élément de dégagement (3).

2. Boîtier (1) selon la revendication 1, **caractérisé en ce que** l'élément de fixation (2) et l'élément de dégagement (3) sont agencés l'un en face de l'autre sur la section de raccordement (4).

3. Boîtier (1) selon l'une quelconque des revendications 1 ou 2, **caractérisé en ce que** l'élément de fixation (2) est réalisé d'une seule pièce avec la section de raccordement (4).

4. Boîtier (1) selon l'une quelconque des revendications 1 à 3, **caractérisé en ce que** l'élément de dégagement (3) est réalisé d'une seule pièce avec la section de raccordement (4).

5. Boîtier (1) selon l'une quelconque des revendications 1 à 4, **caractérisé en ce que** l'élément de dégagement (3) est réalisé de sorte qu'il peut être saisi au moyen d'un outil de préhension.

6. Boîtier (1) selon l'une quelconque des revendications 1 à 5, **caractérisé en ce que** l'élément de fixation (2) est réalisé de sorte qu'il peut être détaché de l'élément de retenue de la machine, du système technique ou du mur de bâtiment en exerçant une force de traction.

7. Boîtier (1) selon l'une quelconque des revendications 1 à 6, **caractérisé en ce que** la structure ondulée élastiquement déformable (40) est formée par au moins deux élévations annulaires (400, 401) et au moins une dépression annulaire (402) entre les élévations (400, 401).

8. Boîtier (1) selon l'une quelconque des revendications 1 à 7, **caractérisé en ce que** la section de raccordement (4) est réalisée d'une seule pièce avec le fond de boîtier (10).
